(19) Europäisches Patentamt European Patent Office Office européen des brevets

(11) **EP 3 358 480 B1**

(12) **EUROPEAN PATENT SPECIFICATION**

(45) Date of publication and mention of the grant of the patent:
**01.01.2020 Bulletin 2020/01**

(21) Application number: **16851533.6**

(22) Date of filing: **27.09.2016**

(51) Int Cl.:
*G06F 17/50* <sup>(2006.01)</sup>    *G01B 11/24* <sup>(2006.01)</sup>
*G01C 15/00* <sup>(2006.01)</sup>    *G01S 17/89* <sup>(2006.01)</sup>
*G06T 19/00* <sup>(2011.01)</sup>

(86) International application number:
**PCT/JP2016/078452**

(87) International publication number:
**WO 2017/057362 (06.04.2017 Gazette 2017/14)**

(54) **DRAWING  CREATION DEVICE AND DRAWING CREATION METHOD**

VORRICHTUNG ZUR ERZEUGUNG VON ZEICHNUNGEN UND VERFAHREN ZUR ERZEUGUNG VON ZEICHNUNGEN

DISPOSITIF ET PROCÉDÉ DE CRÉATION DE DESSIN

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.10.2015  JP 2015195768**

(43) Date of publication of application:
**08.08.2018   Bulletin 2018/32**

(73) Proprietor: **FUJIFILM Corporation**
**Tokyo 106-8620 (JP)**

(72) Inventors:
• **SATO, Tsuneo**
  **Tokyo 107-0052 (JP)**
• **KUBOTA, Satoshi**
  **Tokyo 107-0052 (JP)**
• **NEGORO, Masayuki**
  **Tokyo 107-0052 (JP)**

(74) Representative: **Klunker IP**
**Patentanwälte PartG mbB**
**Destouchesstraße 68**
**80796 München (DE)**

(56) References cited:
| | |
|---|---|
| JP-A- 2013 108 927 | JP-A- 2015 011 399 |
| JP-A- 2015 147 481 | US-A1- 2005 201 611 |
| US-A1- 2006 110 026 | US-A1- 2013 135 440 |

## Description

## BACKGROUND OF THE INVENTION

1. Field of the Invention

The present invention relates to a drawing creation apparatus and a drawing creation method, and particularly relates to a technique which conveniently creates a drawing of a large structure such as a bridge and a dam.

2. Description of the Related Art

It is necessary to regularly perform an inspection on a social infrastructure such as a bridge. In a case of the inspection of the structure, a drawing such as a design drawing of the structure is necessary, however, there is a case in which a drawing is dispersed and disappeared in old structure. In this case, there is a problem that huge cost and effort are taken to measure the structure and newly create a drawing.

JP2004-272459A discloses an automatic generation device which automatically generates three-dimensional shape data with high precision with respect to a plant, building road, a cultural building, and the like, by using a technique called as a laser scanning. In addition, JP2004-272459A discloses a technique for automatically combining a plurality of range images which are obtained from a plurality of measurement points.

The automatic generation device disclosed in JP2004-272459A performs a segmentation for extracting an edge and a face of a plurality of point group data having three-dimensional coordinates, and determines the three-dimensional shape on the basis of segment information which is generated by the segmentation and a predetermined function (plane equation or curved surface equation).

In addition, a method is described below as a method in which an automatic matching is performed on the plurality of range images obtained from the plurality of measurement points, and the whole range images are converted into a global coordinate system.

First, it is assumed that randomly three segments are selected from each of the range images and the three segments are corresponding segments. Next, a rotation matrix and a movement amount vector are estimated, from the corresponding segments, and a conformity degree of segments which correspond with each other in a case in which two range images are overlapped is obtained by using the estimated rotation matrix and the movement amount vector, by a unique value and a unique vector. The processing described above is performed by a combination of the whole segment, and a rotation matrix and a movement amount vector having the highest conformity degree are employed.

In addition, JP2010-236971A discloses a method in which distance images between adjacent frames are gradually connected with each other, by deploying the distance images between the adjacent frames on the same coordinate system using a rotation matrix and a translation vector between each of frames to overlap the distance images and color images such as a bridge, a road, a tunnel wall surface, and the like imaged by a three-dimensional image sensor which is loaded on a vehicle, and a three-dimensional shape of the bridge, the road, the tunnel wall surface, and the like is detected.

US 2005/201611 A1 discloses non-contact imaging apparatus for examining an object having complex surfaces or shape deformations. The imaging apparatus includes at least one imaging device for obtaining a scanned image of the exterior surfaces of the object being examined. A predetermined reference image of an ideal model for the object is stored in a memory. The gauge estimator utilizes processed and registered object data to determine deformation parameters of the object, which are then displayed to an operator as gauging information.

## SUMMARY OF THE INVENTION

JP2004-272459A discloses a disadvantage that the position or the measurement direction of an accurate measurement point is required to match the positions of the plurality of range images, and such information is obtained. Therefore, the automatic generation device disclosed in JP2004-272459A does not use the information on the position or the measurement direction of the measurement point as described above, selects the plurality of (random three) segments which are present in each of the range images, estimates the rotation matrix and the movement amount vector from the corresponding segments in each of the range images, and obtains the conformity degree of the segments which correspond with each other in a case in which each of the range images is overlapped with each other by using the estimated rotation matrix and the movement amount vector, by the unique value and the unique vector.

Therefore, three or more segments corresponding to each of the range images are required to be included in each of the range images, a shape of each segment is required to have a three-dimensional shape appropriate to a predetermined function (plane equation or curved surface equation), and in a case in which the three or more segments satisfying such a condition is not present in each of the range images, the invention disclosed in JP2004-272459A is not able to be employed.

The invention disclosed in JP2010-236971A is also a method in which the position or the imaging direction of the imaging point is not detected, a translation and a rotation of a camera coordinate system is detected for each frame, and the distance image between the adjacent frames, and the like are combined (connected with each other).

In addition, the inventions disclosed in JP2004-272459A and JP2010-236971A connects a plurality of images with each other by using any rotation matrix and movement amount vector, and in a case in which the number of the connected images is increased, have a problem that an accumulation error by the connection becomes large.

The present invention is made in consideration of such circumstance, and an object of the present invention is to provide a drawing creation apparatus and a drawing creation method capable of conveniently creating a drawing of a structure such as a bridge, without generating an accumulation error by a connection of an image.

The present invention provides a drawing creation apparatus according to claim 1 of the appended claims.

The invention further provides a method according to claim 14 of the appended claims.

In order to achieve the object, the invention according to an aspect comprises: an outer shape acquisition unit that acquires an outer shape of an outline of the structure which is a creation target of a drawing; a distance image capture device that captures the structure, and captures distance images including annex information indicating an imaging position and an imaging direction; a distance image acquisition unit that acquires a plurality of distance images of a plurality of portions configuring the structure, the distance images being obtained by capturing by the distance image capture device; a connection processing unit that connects the distance images of the plurality of portions with each other which are acquired by the distance image acquisition unit, by using the outer shape of the structure acquired by the outer shape acquisition unit and the annex information on the distance images; and a drawing creation unit that creates the drawing of the structure from the distance images connected with each other by the connection processing unit.

According to an aspect of the present invention, the outer shape of the outline of the structure which is the creation target of the drawing is acquired. The outer shape of the outline of the structure may be, for example, in a case in which the structure is a bridge, a plane shape determined by the length and the width of the bridge. The distance image capture device captures the distance images including the annex information indicating the imaging positions and the imaging directions, which captures the structure in the plurality of imaging positions and imaging directions. The distance image acquisition unit acquires the distance images of the plurality of portions configuring the structure, which are obtained by capturing the distance image capture device. The connection processing unit connects the distance images of the plurality of portions with each other, which are acquired by the distance image acquisition unit, by using the outer shape of the structure and the annex information on the distance images. The using the annex information (imaging position and imaging direction) of the distance images may be converting the distance images into a three-dimensional coordinates of a global coordinate system. In addition, in a case in which the outer shape of the structure is expressed on the global coordinate system, it is possible to connect the distance images with each other by inserting the distance images which are converted into the global coordinate system into the outer shape of the structure of the global coordinate system thereof. In addition, the drawing creation unit automatically creates the drawing of the structure from the distance images which are connected with each other. Since the distance images are connected with each other by combining the distance images to the outer shape of the structure as described above, an accumulation error by the connection of the distance images does not occur, and it is possible to conveniently create the drawing of a large structure such as a bridge.

In the drawing creation apparatus according to another aspect of the present invention, it is preferable that the distance image capture device comprises an estimation unit that estimates the number of the times of capturing from the outer dimension of the outline of the structure, and a first notification unit that notifies a result estimated by the estimation unit.

In the drawing creation apparatus according to further another aspect of the present invention, the distance image capture device comprises a global positioning system and a azimuth sensor, and uses GPS information and azimuth information acquired from the global positioning system and the azimuth sensor, respectively, at the time of capturing the distance images, as the annex information indicating the imaging position and the imaging direction.

In the drawing creation apparatus according to further another aspect of the present invention, it is preferable that the distance image capture device comprises a second notification unit that notifies information indicating which position of the whole structure is captured, in a case in which the structure is captured. Therefore, in a case in which the structure is captured by dividing the capture into a plurality of times, it is possible to support the imaging position and the imaging direction.

In the drawing creation apparatus according to further another aspect of the present invention, it is preferable that the drawing creation apparatus comprises a first display unit that displays the distance images as visualization which are captured by the distance image capture device, or a second display unit that displays a visualization image acquired by a capture device which captures the visualization image of the same capture area as that of the distance image capture device. Since the visualization image is displayed by the first display unit or the second display unit, it is possible to capture the structure while viewing the visualization image.

In the drawing creation apparatus according to further another aspect of the present invention, it is preferable that the drawing creation apparatus comprises a third display unit that displays a previously-captured area where the capture of the distance images is performed with respect to the structure and a non-captured area where the capture of the distance images is not performed with respect to the structure, in a distinguishable manner. Therefore, it is possible to capture the structure so that the non-captured area of the structure is not remained.

In the drawing creation apparatus according to further another aspect of the present invention, it is preferable that the distance image capture device is a time of flight type camera. However, a three-dimensional laser scanner or a stereo camera may be used as the distance image capture device.

In the drawing creation apparatus according to further another aspect of the present invention, it is preferable that the drawing creation unit creates a diagram formed by connecting points with each other, which are seen as a contour of the structure from the distance images which are connected with each other. For example, in a case in which each pixel (distance information) of the distance image is set as the visualization image which is converted into the luminance corresponding to the distance, the change point of the luminance in the visualization image thereof is the point seen as the contour of the structure.

In the drawing creation apparatus according to further another aspect of the present invention, it is preferable that the drawing creation apparatus comprises a first manual correction unit that manually corrects the connection of the distance images of the plurality of portions by the connection processing unit. For example, the positions (specifically, imaging position and imaging direction used at the time of coordinate conversion) of the distance images are manually corrected, so that the outer shape of the structure and the visualization image of the distance image are displayed so as to overlap, and a portion corresponding to the outer shape among the distance image and the outer shape correspond with each other.

In the drawing creation apparatus according to further another aspect of the present invention, it is preferable that the drawing creation apparatus comprises a second manual correction unit that manually corrects the drawing of the structure which is created by the drawing creation unit. For example, in a case in which a portion corrupting the diagram among the created drawing, or the like is present, a correction for successively connecting the diagrams or the like is performed.

In the drawing creation apparatus according to further another aspect of the present invention, it is preferable that the drawing creation apparatus comprises a dimension appending unit that appends a dimension line and a dimension in the drawing of the structure. Since the distance images (three-dimensional information) of the whole structure are present, it is possible to obtain the distance (dimension) between random positions of the structure and append the obtained dimension in the drawing.

In the drawing creation apparatus according to further another aspect of the present invention, it is preferable that the outer shape acquisition unit acquires the outer shape of the structure from map information expressing the outer shape of the outline of the structure.

In the drawing creation apparatus according to further another aspect of the present invention, it is preferable that the map information is map information acquirable from a map information system, or map information provided by a map information provision service on the Internet.

In the drawing creation apparatus according to further another aspect of the present invention, it is preferable that the drawing creation apparatus comprises an unmanned aerial vehicle that loads the distance image capture device and a control unit that controls the unmanned aerial vehicle, and the distance image acquisition unit acquires the plurality of distance images which are obtained by capturing by the distance image capture device loaded on the unmanned aerial vehicle. It is preferable that a drone having an automatic driving function is used as the unmanned aerial vehicle.

In the drawing creation apparatus according to further another aspect of the present invention, it is preferable that the distance image capture device successively captures the distance images at a regular frame rate, and the distance image acquisition unit acquires the images of the plurality of portions used in the connection among the successively captured distance images.

A drawing creation method according to further another aspect of the present invention comprises a step of acquiring an outer shape of an outline of a structure which is a creation target of a drawing; a step of acquiring a plurality of distance images of a plurality of portions configuring the structure, which are distance images being acquired by a distance image capture device which captures the structure; a step of connecting the acquired distance images of the plurality of portions with each other, by using the acquired outer shape of the structure and annex information on the distance images; and a step of creating the drawing of the structure from the distance images which are connected with each other.

According to the present invention, since the distance images of the plurality of portions of the structure, which are captured by the distance image capture device, are connected with each other, by using the outer shape of the structure and the annex information (imaging position and imaging direction) of the distance images, and the drawing of the structure is created from the distance images which are connected with each other, an accumulation error by the connection of the images does not occur, and it is possible to conveniently create the drawing of a large structure such as a bridge.

**BRIEF DESCRIPTION OF THE DRAWINGS**

Fig. 1 is a main part block diagram illustrating an embodiment of a drawing creation apparatus according to the present invention.

Fig. 2 is a block diagram illustrating an internal configuration of a TOF camera illustrated in Fig. 1.

Fig. 3 is a diagram illustrating an operation processing of a distance between an object $T_1$ and a close object $T_2$ in a measurement area.

Fig. 4 is a diagram illustrating an example of a distance image file in which a distance image and annex information are related to each other.

Fig. 5 is a diagram illustrating a map (aerial photograph) including a structure of a target.

Fig. 6 is a diagram illustrating an outer shape of a bridge, the number of captures in which a bridge is divided and captured, a global coordinate system, and the like.

Fig. 7 is a diagram illustrating a visualization image corresponding to three-dimensional information on a portion of the bridge.

Fig. 8 is a diagram created according to the three-dimensional information on the portion of the bridge, and the diagram in which a dimension is appended.

Fig. 9 is a block diagram of an unmanned aerial vehicle.

Fig. 10 is a diagram used for describing another embodiment of an image sensor which may be applied to the TOF camera.

Fig. 11 is a flowchart illustrating an embodiment of a drawing creation method according to the present invention.

## DESCRIPTION OF THE PREFERRED EMBODIMENTS

Hereinafter, embodiments of a drawing creation apparatus and a drawing creation method according to the present invention will be described with reference to the accompanying drawings.

[Drawing creation apparatus]

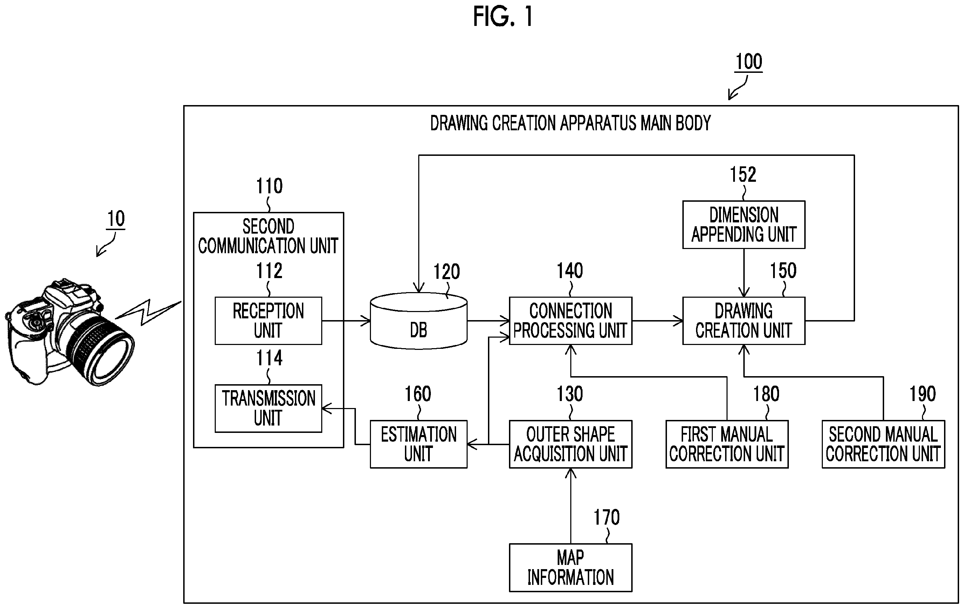

Fig. 1 is a main part block diagram illustrating the embodiment of the drawing creation apparatus according to the present invention.

As illustrated in Fig. 1, the drawing creation apparatus is configured from a time of flight type camera 10 (hereinafter "TOF camera") functions as a distance image capture device 10 and a drawing creation apparatus main body 100.

In the drawing creation apparatus of the present embodiment, the TOF 10 and the drawing creation apparatus main body 100 are separated from each other, and have a wireless communication function which enables the TOF 10 and the drawing creation apparatus main body 100 to communicate with each other. However, the drawing creation apparatus may be configured from a TOF camera integrated portable device such as a TOF camera portable information terminal, a smart phone, or a tablet terminal, and in this case, the wireless communication function is not necessary.

<TOF camera 10>

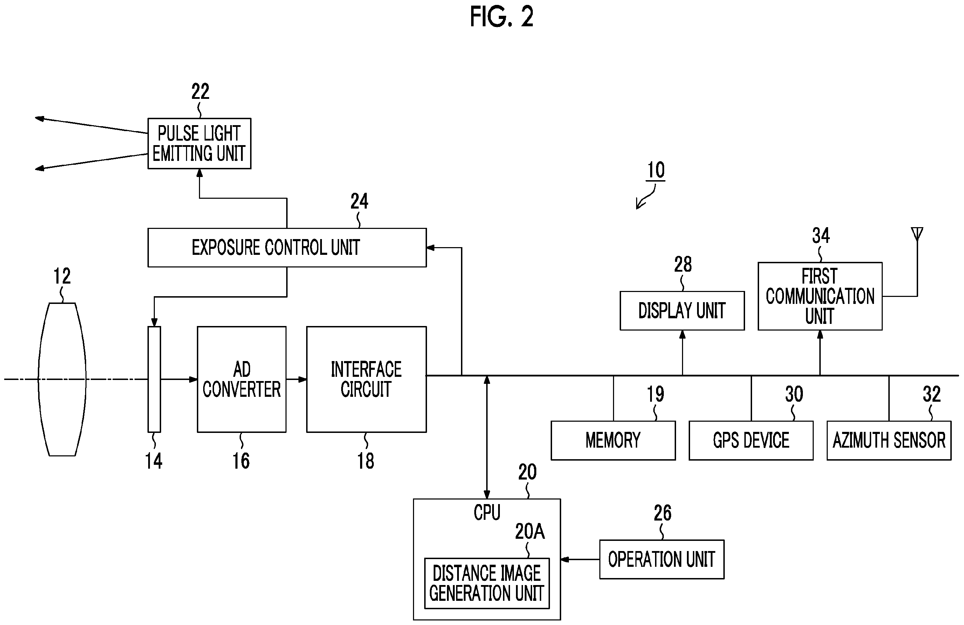

Fig. 2 is a block diagram illustrating an internal configuration of the TOF camera 10 illustrated in Fig. 1.

The TOF camera 10 illustrated in Fig. 2 is a camera which obtains the distance to a subject by emitting light on a subject and measuring the time taken to receive reflection light thereof by a sensor, and mainly configured from an image forming lens 12, a distance image sensor 14, an Analog-to-Digital (A/D) converter 16, an interface circuit 18, a memory 19, a Central Processing Unit (CPU) 20, a pulse light emitting unit 22, an exposure control unit 24, an operation unit 26, a display unit 28 such as a liquid crystal display device, a Global Positioning System (GPS) (hereinafter, referred to as "GPS device") 30, a azimuth sensor 32, and a first communication unit 34.

The pulse light emitting unit 22 includes a near-infrared ray light emitting diode (near-infrared LED), and generates pulse light having a regular pulse width in synchronization with a light emitting timing signal from the exposure control unit 24. In addition, the pulse light emitting unit 22 emits the pulse light on the whole capture area captured through at least image forming lens 12. Further, the pulse light emitted from the near-infrared LED of the pulse light emitting unit 22 is near-infrared ray.

The image forming lens 12 image-forms the reflection light (including reflection light of the pulse light which is emitted from the pulse light emitting unit 22 and reflected from the surface of the structure) from the subject (structure) on the distance image sensor 14.

The distance image sensor 14 is configured by a Complementary Metal-Oxide Semiconductor (CMOS) driver having a vertical driver, a horizontal driver, and the like, and a CMOS type image sensor driven by a timing generator. In addition, the distance image sensor 14 is not limited to the CMOS type, and may be an XY address type or a Charge Coupled Device (CCD) type image sensor.

It is preferable for the distance image sensor 14 to have a plurality of light receiving elements (photodiodes) arranged in a two-dimensional shape, and a band pass filter through which only a wavelength band of the pulse light of the near-infrared emitted from the pulse light emitting unit 22 passes or a visible light cut filter which removes visible light is provided on an incident side surface of the plurality of light receiving elements. Therefore, the plurality of light receiving elements of the distance image sensor 14 function as a pixel sensitive to the near-infrared ray.

The distance image sensor 14 controls the exposure period (exposure time and exposure timing) by a shutter control signal added from the exposure control unit 24. In each light receiving element of the distance image sensor 14, an electric charge corresponding to an amount of light of the incident near-infrared ray during the exposure period is accumulated. In addition, a pixel signal (analog signal corresponding to electric charge accumulated in each pixel) corresponding to the amount of incident light of the near-infrared ray from the subject is read from the distance image sensor 14.

Here, although details of the exposure control unit 24 will be described later, the exposure control unit 24 sequentially performs a first exposure control in which the pulse light is emitted from the pulse light emitting unit 22, and a difference between amounts (light receiving times of pulse lights) of exposures in corresponding light receiving elements of the distance image sensor 14 occurs according to at least the distance of subject (structure), and a second exposure control in which the whole light receiving element of the distance image sensor 14 exposes the whole pulse light which is reflected from the structure, which is the second exposure control in which the pulse light is emitted from the pulse light emitting unit 22, and the phase of an exposure start for the pulse light is different from a phase of the exposure start for the pulse light of the first exposure control.

The analog signal read from the distance image sensor 14 after the exposure control by the exposure control unit 24 is converted into a digital signal by the A/D converter 16, and maintained in the memory 19 through the interface circuit 18 which functions as an image input controller.

The memory 19 stores various types of data and the like necessary in processing in the CPU 20, and functions as a working memory of the CPU 20. In addition, the memory 19 is able to function as a recording medium which records the distance image captured by the TOF camera 10.

The operation unit 26 includes a power switch, a shutter button, a mode selection unit, and the like, and an instruction input in the operation unit 26 is added to the CPU 20.

Although descriptions of the CPU 20 will be described later, the CPU 20 has a function as a device control unit which generally controls each unit such as the exposure control unit 24 according to the instruction input in the operation unit 26, and a function as a distance image generation unit 20A.

The distance image generation unit 20A generates a three-dimensional distance image of the structure of the capture target, on the basis of a sensor output of the distance image sensor 14.

<Basic principle of TOF method>

Next, a basic principle for acquiring the three-dimensional distance image by the TOF camera 10 is described.

The pulse light emitted from the pulse light emitting unit 22 of the TOF camera 10 enters to a subject (structure) in a measurement area, and the pulse light reflected from the structure is image-formed (received) by the distance image sensor 14 through the image forming lens 12.

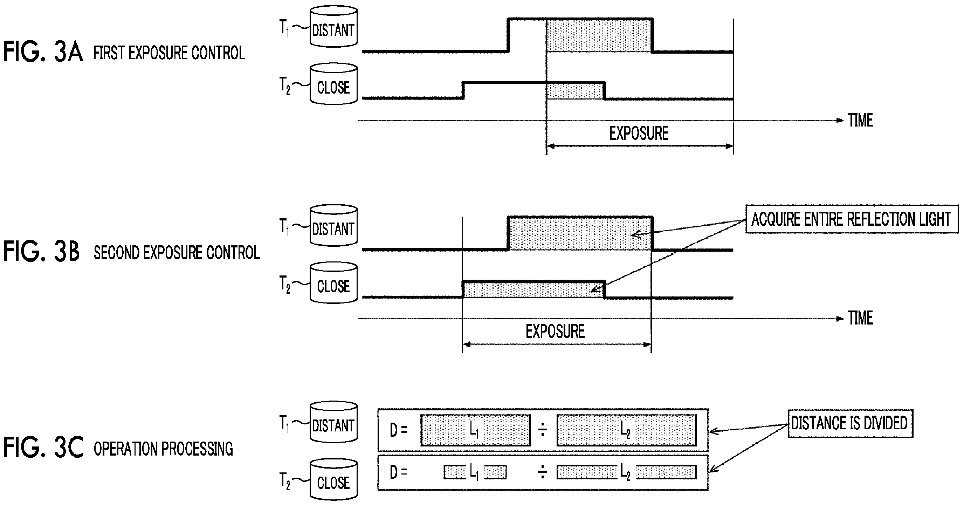

Fig. 3 is a diagram illustrating an operation processing of the distance between a distant object $T_1$ and a close object $T_2$ in the measurement area.

The pulse light emitting unit 22 is pulse-driven by the exposure control unit 24, however, as illustrated in Figs. 3A and 3B, the distance image sensor 14 sequentially performs the two exposure controls of the first exposure and the second exposure by the exposure control unit 24, in synchronization with the pulse driving of the pulse light emitting unit 22.

The first exposure control illustrated in Fig. 3A is an exposure control for controlling the exposure period so that the pulse light is emitted from the pulse light emitting unit 22, and a difference between amounts of exposures in corresponding light receiving elements of the distance image sensor 14 occurs according to at least the distance of subject. After the pulse light is emitted from the pulse light emitting unit 22, an exposure starts after a certain time (time taken for light to return from the farthest object which may be measured) has elapsed, and the exposure ends after a time (predetermined exposure time) taken for the whole pulse light which is reflected from at least the farthest subject returns has elapsed.

According to the first exposure control described above, in a case in which the reflection rate of the object is consistent, in a state of a comparison between the distant object $T_1$ and the close object $T_2$, an amount of exposure increases by the distant object $T_1$.

The second exposure control illustrated in Fig. 3B is an exposure control in which the pulse light is emitted from the pulse light emitting unit 22, and the phase of an exposure start for the pulse light is different from a phase of the exposure start for the pulse light of the first exposure control, and an exposure control for removing a change of the amount of exposure of the distance image sensor 14 by a difference of the reflection rate of the object. In the present example, the second exposure control is an exposure control in which the whole light receiving element of the distance image sensor 14 exposures the whole pulse light which is reflected from the object. Specifically, the exposure starts in synchronization with the emission timing of the pulse light which is emitted from the pulse light emitting unit 22, and the exposure ends after a certain time (predetermined exposure time taken for the whole pulse light to return from the farthest object which may be at least measured) has elapsed. In addition, the "predetermined exposure time" in the first exposure control and the "predetermined exposure time" in the second exposure control are the same time, however, as described above, the phase of the exposure start for the pulse light varies.

According to the second exposure control described above, regardless of the distance of the object, the amount of exposure varies according to the reflection rate of the object, and it is possible to acquire information corresponding to the reflection rate of the object by the amount of exposure which is obtained by the first exposure control.

Next, as illustrated in Fig. 3C, in a case in which the sensor outputs (output data of one pixel) corresponding to each amount of exposure acquired from the distance image sensor 14 by the first exposure control and the second exposure control are set as first data $L_1$ and second data $L_2$, respectively, the distance image generation unit 20A of the CPU 20 calculates distance information D corresponding to the distance of the object by the following Expression,

$$[Expression\ 1]$$

$$D = L_1 \div L2$$

That is, according to Expression 1, division data obtained by dividing the first data $L_1$ by the second data $L_2$ is calculated. The division data is data (distance information D) corresponding to a relative distance in which an influence of the reflection rate of the object is removed and an influence of the amount of light of the pulse light which is not uniform on the whole screen is removed. The distance information D is information corresponding to the time (flying time) taken for the light is emitted on the object and the reflection light thereof is received by the distance image sensor. In addition, it is possible to obtain an absolute distance of the object on the basis of the first data $L_1$ and the second data $L_2$.

In addition, the distance image generation unit 20A may generate the three-dimensional distance image, by acquiring the distance information D for each of all pixels of the distance image sensor 14. Here, the distance image is a two-dimensional distribution image of a distance value (distance information D) to the subject (structure) obtained by the TOF camera 10 which is the distance image capture device, and each pixel of the distance image has the distance value (distance information).

Since the distance image is not appropriate to a visualization image, in a case in which the distance image is recognized, it is necessary to convert the distance image into the visualization image. For example, each pixel (distance information) of the distance image is converted into the luminance corresponding to the distance by the CPU 20 illustrated in Fig. 2, or converted into a color corresponding to the distance, and the converted distance image is output to the display unit 28 (first display unit). Therefore, it is possible to recognize the distance image (captured structure) on a screen of the display unit 28.

In addition, in a case in which an optical finder which has a view corresponding to a capture area of the distance image by the TOF camera 10 is provided in the TOF camera 10, it is possible to identify the capture area of the distance image by the optical finder.

In Fig. 2, the GPS device 30 receives GPS signals transmitted from a plurality of GPS satellites, performs a positioning operation processing on the basis of the plurality of received GPS signals, and acquires position information (GPS information) specified by the current latitude, longitude, and altitude of the TOF camera 10. In a case in which the capture of the distance image is performed by the TOF camera 10, the CPU 20 acquires the GPS information from the GPS device 30 as information indicating the imaging position.

In addition, the azimuth sensor 32 is a sensor which detects azimuth information indicating the imaging direction of the TOF camera 10, and is configured by a gyro sensor, a geomagnetic sensor, and the like. Here, the imaging direction refers to an optical axis direction and a rotation angle of the optical axis of the image forming lens 12. The optical axis direction is a direction specified by a azimuth angle and an elevation angle (or depression angle). The rotation angle of the optical axis is an inclination angle around the optical axis of the camera setting a case in which the TOF camera 10 is in the horizontality as 0°. In a case in which the capture of the distance image is performed by the TOF camera 10, the CPU 20 acquires the azimuth information indicating the imaging direction of the distance image from the azimuth sensor 32.

In a case in which the capture of the distance image is performed according to a capture instruction from the operation unit 26, the CPU 20 relates and stores the distance image generated by the distance image generation unit 20A, the GPS information indicating the imaging position acquired from the GPS device 30 which is the annex information on the distance image, and the azimuth information indicating the imaging direction acquired from the azimuth sensor 32, in the memory 19.

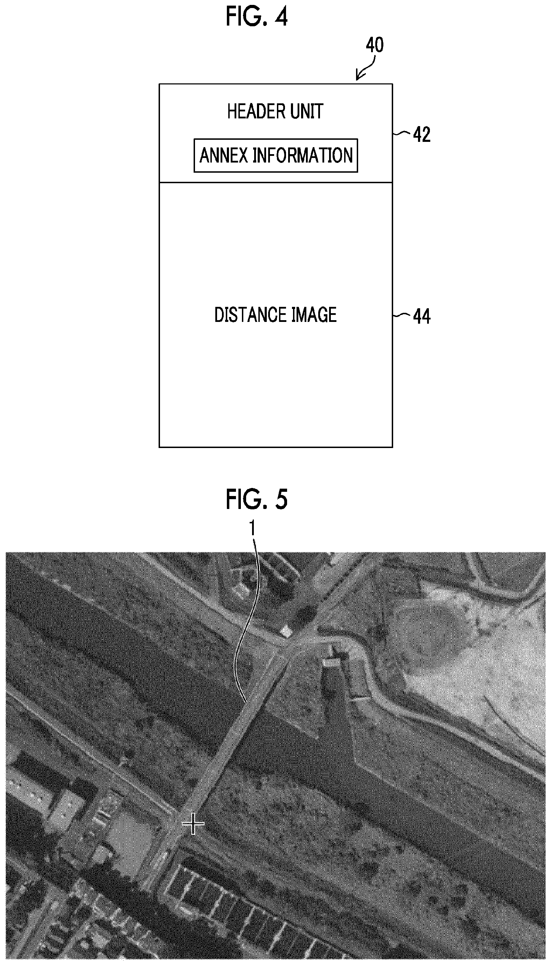

Fig. 4 is a diagram illustrating an example of a distance image file in which the distance image and the annex information are related to each other. The distance image file 40 illustrated in Fig. 4 is configured by recording the annex information including the GPS information indicating the imaging position and the azimuth information indicating the imaging direction in a header unit 42, and recording the distance image in a main body unit 44 of the distance image file 40. In addition, a method of relating the distance image, the GPS information and the azimuth information indicating the imaging direction is not limited to the method described above, and, for example, the distance image file in which the distance image is recorded, and a text file in which the annex information indicating the imaging position and the imaging direction at the time of the capture may be related to each other by a file name, or the like.

The first communication unit 34 is a part which performs short range wireless communication or wireless communication through a network between the first communication unit 34 and the second communication unit 110 of the drawing creation apparatus main body 100 illustrated in Fig. 1. In the present example, the first communication unit 34 transmits the captured distance images (distance image file) collectively to the drawing creation apparatus main body 100 whenever the distance image is captured or after the capture of the plurality of distance images (distance images of a plurality of portions) ends. In addition, although details of the second communication unit 110 of the drawing creation apparatus main body 100 will be described later, the second communication unit 110 of the drawing creation apparatus main body 100 transmits information for supporting the capture of the distance image by the TOF camera 10, to the TOF camera 10.

<Drawing creation apparatus main body 100>

The drawing creation apparatus main body 100 illustrated in Fig. 1 is mainly configured from the second communication unit 110, a database 120, an outer shape acquisition unit 130, a connection processing unit 140, a drawing creation unit 150, a dimension appending unit 152, an estimation unit 160, a first manual correction unit 180, a second manual correction unit 190, and the like.

In the present example, the outer shape acquisition unit 130 acquires the outer shape of the outline of the structure which is the creation target of the drawing, from map information 170 expressing the outer shape of the outline of the structure. Here, the map information 170 is map information which may be acquired from Geographic Information System (GIS), or map information ("Google map" (registered trademark) position information acquisition page) provided by a map information provision service on Internet, and map information including additional information such as GPS information usable on a computer is preferable.

As illustrated in Fig. 5, by the map information 170, map (in the present example, aerial photograph) including a structure (in the present example, a bridge 1) of an object is displayed on a screen (not shown) of a computer, and a cursor is shifted to a plurality of locations determining an outer shape of the bridge 1. The outer shape acquisition unit 130 acquires GPS information on the plurality of locations which are designated by the cursor of the bridge 1 from the map information 170. Here, the acquisition of the GPS information by the outer shape acquisition unit 130 includes a method in which GPS information corresponding to the position designated by the cursor is automatically acquired through a computer software having an edition function of the map information 170, or a method in which the GPS information displayed on the screen corresponding to the position designated by the cursor is read with eyes, and read GPS information is manually input, so as to acquire the GPS information. In addition, it is possible to acquire the outer shape of the bridge 1 which is more accurate, by estimating an optimum function of the outer of the bridge 1 by least squares, on the basis of GPS information on a plurality of points of the bridge 1, along the outer of the bridge 1 displayed on the screen of the computer with the cursor.

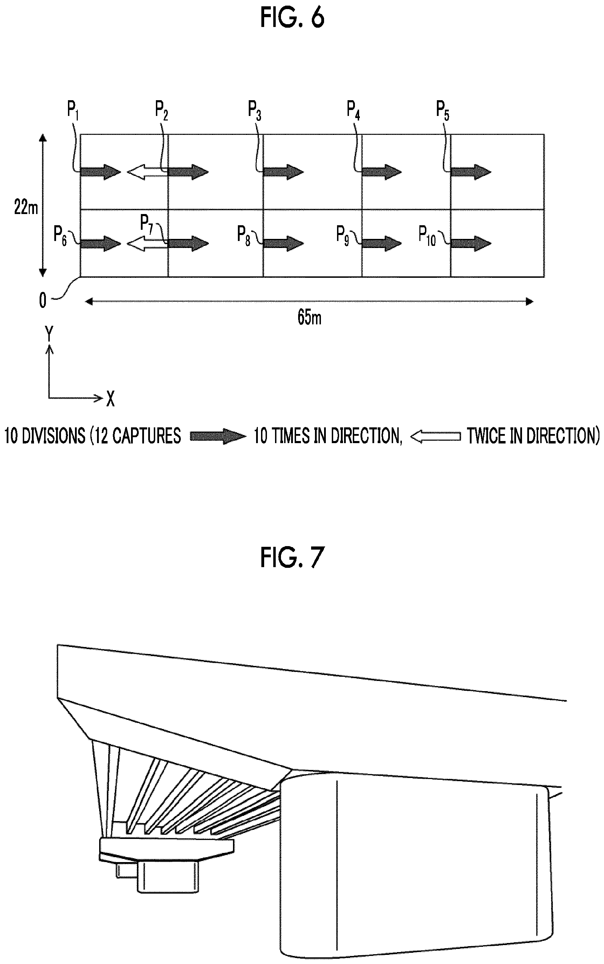

The estimation unit 160 is a part which estimates the number of the times of capturing and the like by the TOF camera 10, from the outer shape of the bridge 1 acquired by the outer shape acquisition unit 130, and estimates the number of the times of capturing on the basis of the whole size (outer dimension) of the bridge 1 (structure) and the measurement area (measurement area having high reliability of measurement) by the TOF camera 10. For example, as illustrated in Fig. 6, in a case in which the length (length of horizontal direction) of the bridge 1 is 65m, the width of the bridge 1 is 22m, and the measurement area by the TOF camera 10 is 15m×15m, as illustrated in Fig. 6, the bridge 1 is captured by dividing the bridge 1 into 10 divisions (12 times).

Now, in Fig. 6, in a case in which a corner of the lower left of the bridge 1 is disposed at the origin O of global coordinate system (XYZ coordinate system), the horizontal direction of the bridge 1 corresponds to the X direction, and the width direction of the bridge 1 corresponds to the Y axis direction, the capture is performed 10 times in a positive direction of the X axis from each of the 10 imaging positions $P_1$ to $P_{10}$ shown in Fig. 6, and the capture is performed twice in a negative direction of the X axis from each of two imaging positions $P_2$ and $P_7$.

In addition, in the imaging positions $P_2$ and $P_7$, the reason why the capture is performed twice in each of the positive direction and the negative direction of the X axis is because an area (occlusion area) in which the object behind a back is hidden by the object in front of configuring the bridge 1 is generated, in the capture of 10 times of only the positive direction of the X axis. In order to capture the occlusion area, the capture in the negative direction of the X axis is also performed. In addition, in the whole of 10 imaging positions $P_1$ to $P_{10}$, the capture (capture of total 10×2 times) of twice in the positive direction and the negative direction of the X axis may be performed, however, in a case in which the bridge 1 is configured by a repeat of the same structure, the number of the times of capturing of one direction (negative direction) may be reduced like the present example, and an occlusion area generated by reducing the number of the times of capturing may be inferred.

The estimation unit 160 estimates the number (12 times) of the captures, the imaging positions $P_1$ to $P_{10}$, the imaging directions, and the like, as described above, and transmits an estimation result to the TOF camera 10 through the second communication unit 110 (transmitter 114).

The first communication unit 34 of the TOF camera 10 illustrated in Fig. 2 receives the result estimated by the estimation unit 160, and the CPU 20 displays the estimated result which is received through the first communication unit 34, on the display unit 28 which functions as the first notification unit. For example, the number of the times of capturing and the like may be displayed by a graph as illustrated in Fig. 6, rather than displaying the number of the times of capturing and the like by a text on the display unit 28.

It is possible for a photographer to capture the distance images of the plurality of portions configuring the bridge 1 while determining the imaging position, the imaging direction, or the like on the basis of the result estimated by the estimation unit 160, which is displayed on the display unit 28 of the TOF camera 10. For example, the photographer performs the capture of the distance image of a direction designated by an arrow, by performing a shift to an imaging position of any of the imaging positions $P_1$ to $P_{10}$ or an imaging position of the vicinity thereof as illustrated in Fig. 6, while viewing the GPS information positioned by the GPS device 30. Therefore, it is possible to capture the distance images of the plurality of portions configuring the bridge 1, by repeating the capture of the image distance one by one while changing the imaging position.

The CPU 20 of the TOF camera 10 displays information which indicates a portion of the whole of the bridge 1 corresponding to the portion captured at this time in a case in which the structure (bridge 1) is captured, on the display unit 28 which functions as a second notification unit. For example, the CPU 20 displays the whole outer shape of the bridge 1 which is divided into 10 divisions as illustrated in Fig. 6 on the display unit 28 and the portion (one division) captured at this time so that the portion is distinguishable from the other divisions. In this case, it is preferable that the visualization image generated from the distance images which are successively captured by the TOF camera 10 is displayed on the display unit 28 which functions as the first display unit, or a live view image obtained from a capture unit which captures a visualization image of an image angle equal to the distance image captured by the TOF camera 10 is displayed on the display unit 28 which functions as the second display unit, and the portion of the whole of the bridge 1 corresponding to the portion captured at this time on the display unit 28. Therefore, it is possible for the photograph to identify the portion of the whole of the bridge 1 corresponding to the portion captured at this time, and to shift the distance image of the portion thereof to the imaging position necessary in capturing.

In addition, the CPU 20 displays a previously-captured area where the capture of the distance image is performed with respect to the structure (bridge 1) and a non-captured area where the capture of the distance images is not performed with respect to the structure on the display unit 28 which functions as a third display unit so that the previously-captured area and the non-captured area are distinguishable from each other. For example, the CPU 20 displays the outer shape of the whole of the bridge 1 divided into 10 divisions as illustrated in Fig. 6 on the display unit 28, performs a gray out on the previously-captured area (division area where capture is performed among division areas divided into 10 divisions), and displays the previously-captured area and the non-captured area so as to be distinguishable from each other. Therefore, it is possible to capture the bridge 1 so that the non-captured area is not remained.

The distance images (distance image file) are transmitted in a lump from the first communication unit 34 of the TOF camera 10 whenever the distance image is captured or after the capture of the distance images of the whole of the bridge 1 ends. A reception unit 112 of the second communication unit 110 of the drawing creation apparatus main body 100 receives the distance image file transmitted from the TOF camera 10, and stores the received distance image file in the database 120.

The connection processing unit 140 sequentially reads the distance images (12 distance images in the example illustrated in Fig. 6) of the plurality of portions of the bridge 1, which are stored in the database 120, from the database 120, and connects the read distance images each other, by using the outer shape of the bridge 1 acquired by the outer shape acquisition unit 130 and the annex information (GPS information indicating imaging position and azimuth information indicating imaging direction stored in header unit 42 of distance image file 40) of each distance image.

The distance image is three-dimensional information including a diameter and a declination angle of polar coordinates space using the imaging position expressed by the GPS information as the origin. The distance information of each pixel of the distance image corresponds to the diameter, and the position of each pixel in a two-dimensional distribution image of the distance image corresponds to the declination angle. Here, the connection processing unit 140 converts the distance image expressed by the polar coordinates into xyz of triaxial orthogonal coordinates using the imaging position as the origin. For example, the z axis of the triaxial orthogonal coordinates may be used as the imaging direction (optical axis direction), and the x axis and the y axis may be used as the horizontal direction and the vertical direction of a face orthogonal to the z axis, respectively. As described above, the three-dimensional coordinates of the bridge 1 are acquired in a local coordinate system of the TOF camera 10, in which the distance image is converted into the triaxial orthogonal coordinates using the imaging position as the origin.

Then, the connection processing unit 140 converts the three-dimensional coordinates of the bridge 1 in the local coordinate system into the three-dimensional coordinates of the global coordinate system illustrated in Fig. 6.

In this case, the coordinate value (GPS information) of the origin O of the global coordinate system and the azimuth directions of the X axis and the Y axis of the global coordinate system are known from the GPS information at the time of the acquisition of the outer shape of the bridge 1 in advance, and the coordinate value (GPS information indicating imaging position of distance image) of the origin of the local coordinate system is acquired. Therefore, it is possible to obtain a translation vector for converting the coordinate value of the local coordinate system into the coordinate value of the global coordinate system. In addition, it is possible to acquire the information (optical axis direction and rotation angle of optical axis rotation of image forming lens 12) on the imaging direction at the time of capturing the distance image, and to obtain the rotation angle of the each axis rotation of the orthogonal triaxis for converting the coordinate value of the local coordinate system into the coordinate value of the global coordinate system. Therefore, it is possible to convert the coordinate value of the local coordinate system into the coordinate value of the global coordinate system on the basis of the translation vector and the rotation angle, which are obtained by processes described above.

The connection processing unit 140 connects the distance images with each other by converting the distance images sequentially read from the database 120 into the coordinate value of the global coordinate system, by using the annex information indicating the imaging position and the imaging direction appertaining to the distance image. The distance images which are connected with each other as described above become images expressing the three-dimensional information on the whole of the bridge 1.

Ideally, it is possible to obtain the outer shape (plane shape) of the bridge 1 from the three-dimensional information on the whole of the bridge 1, and the outer shape of the bridge 1 obtained from the three-dimensional information on the whole of the bridge 1 is identical to the outer shape acquired by the outer shape acquisition unit 130. However, the outer shape of the bridge 1 obtained from the three-dimensional information on the whole of the bridge 1 is not identical to the outer shape acquired by the outer shape acquisition unit 130, due to an error of the imaging position (GPS information) positioned by the GPS device 30 and an error of the imaging direction detected by the azimuth sensor 32. The connection processing unit 140 corrects the translation vector and the rotation angle used in a case in which each distance image is converted into the coordinate value of the global coordinate system, so that the outer shape (plane shape) of the bridge 1 obtained from the three-dimensional information on the whole of the bridge 1 is identical to the outer shape acquired by the outer shape acquisition unit 130.

In addition, the connection processing unit 140 has a function of correcting the connection of the distance images of the plurality of portions by a correction instruction which is input from the first manual correction unit 180. The first manual correction unit 180 has a display unit (not shown) which displays the outer shape of the structure (bridge 1) and the visualization image of the distance images which are connected with each other, so that the outer shape of the structure (bridge 1) and the visualization image of the distance images which are connected with each other overlap, and outputs the correction instruction for correcting the positions (specifically, imaging positions (translation vector) and imaging direction (angle) at the time of the coordinate conversion) of each distance image to the connection processing unit 140, so that a portion corresponding to the outer shape among each of the distance images displayed on the display unit coincides with the outer shape. The connection processing unit 140 corrects the connection (coordinate conversion of distance image) of the distance images of the plurality of portions by the correction instruction from the first manual correction unit 180.

In addition, in a case in which an area where adjacent distance images overlap is present, the connection processing unit 140 may correct a mutual coordinate conversion so that the three-dimensional coordinate value after a coordinate conversion of the overlap area becomes the same coordinate value.

The drawing creation unit 150 creates the drawing of the structure (bridge 1) on the basis of the distance images which are connected with each other by the connection processing unit 140. The drawing creation unit 150 may create the diagram configured by connecting points seen as the contour of the bridge 1 from the distance images (three-dimensional information on the whole of the bridge 1) which are connected with each other. In addition, the three-dimensional information on the whole of the structure (bridge 1) is obtained. Therefore, it is possible to create six side views (front view, rear view, plan view, bottom view, right side view, and left side view), or create a perspective view, by for example, an orthographic drawing method.

The drawing created by the drawing creation unit 150 is related to the distance images of the plurality of portions and stored in the database 120. The drawing of the structure stored in the database 120 may be read, may be output as a print, or may be displayed on the display unit, as occasion demands.

In addition, the drawing creation unit 150 has a function of correcting the drawing of the structure (bridge 1) by the correction instruction input from the second manual correction unit 190. The second manual correction unit 190 has the display unit (not shown) which displays the drawing created by the drawing creation unit 150, and in a case in which a portion (portion corresponding to occlusion area, and the like) omitted in the drawing displayed on the display unit is present, or in a case in which an apparent error is present in the drawing, the correction instruction of the drawing by a manual is output to the drawing creation unit 150.

The dimension appending unit 152 is a part which appends a dimension line and a dimension in the drawing of the structure (bridge 1) created by the drawing creation unit 150. The dimension appending unit 152 has a display unit which displays the drawing created by the drawing creation unit 150, and may perform an instruction input of the dimension and a portion where the dimension line is input on the display unit. In addition, since the three-dimensional information on the structure is generated by the distance images which are connected with each other, in a case in which the instruction input of the portion where the dimension line is input, it is possible to automatically calculate the dimension of a configuration portion of the structure corresponding to the dimension line, and it is possible to use the calculated dimension as information which is appended in the drawing.

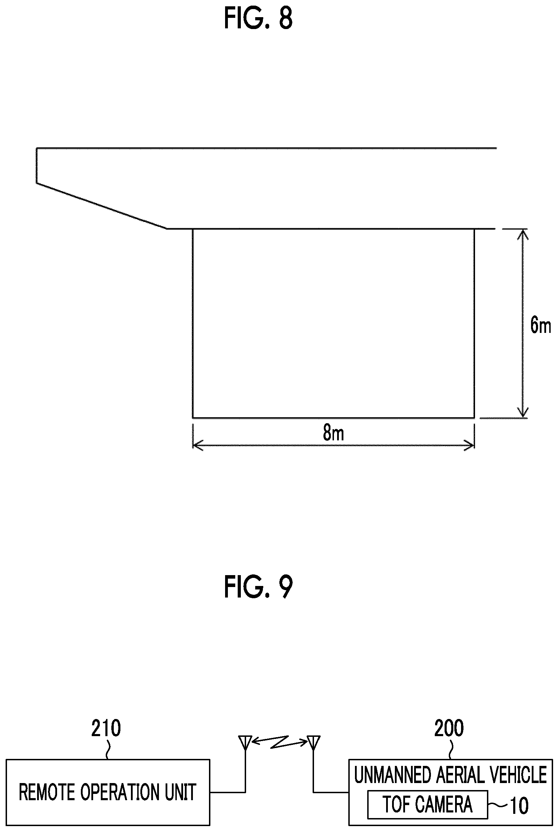

Fig. 7 is a visualization image corresponding to three-dimensional information on a portion of the bridge, and Fig. 8 is a diagram created according to the three-dimensional information on the portion of the bridge. The drawing creation unit 150 appends the dimension line and the dimension in the drawing created on the basis of the instruction input of the dimension and the portion where the dimension line is input from the dimension appending unit 152 as illustrated in Fig. 8.

**<Unmanned aerial vehicle 200>**

There is a case in which it is difficult to move the TOF camera 10 to an appropriate imaging position by a hand and capture a distance image of a structure, according to a structure.

In this case, as illustrated in Fig. 9, it is preferable that the TOF camera 10 is loaded on the unmanned aerial vehicle 200, the unmanned aerial vehicle 200 is operated by the remote operation unit 210, and the distance image of the structure is captured.

The unmanned aerial vehicle 200 includes the TOF camera 10 and a communication unit (first communication unit) which wirelessly transmits the distance image captured by the TOF camera 10. In addition, in a case in which the TOF camera 10 includes the first communication unit 34 (Fig. 2), the unmanned aerial vehicle 200 may not have the first communication unit.

In addition, it is preferable that the unmanned aerial vehicle 200 further includes a capture device which captures a visualization image (live view image) of the same capture area (including substantially the same capture area) as the TOF camera 10, and a communication unit which transmits the live view image captured by the capture device to the remote operation unit 210.

The remote operation unit 210 functions as a control unit which remotely controls the unmanned aerial vehicle 200. The remote operation unit 210 includes a display unit which displays the live view image captured by the capture device of the unmanned aerial vehicle 200, and an operation unit which instructs a flight of the unmanned aerial vehicle 200 or the capture of the TOF camera 10. An operator remotely operates the unmanned aerial vehicle 200 while watching the live view image displayed on the display unit.

In addition, in a case in which the unmanned aerial vehicle 200 is the drone having the automatic driving function, the unmanned aerial vehicle 200 may include a control unit in which a flight route, the imaging position, and the like are programmed in advance, may not use the remote operation unit 210 by controlling the flight of the drone by the control unit, or may supplementary use the remote operation unit 210.

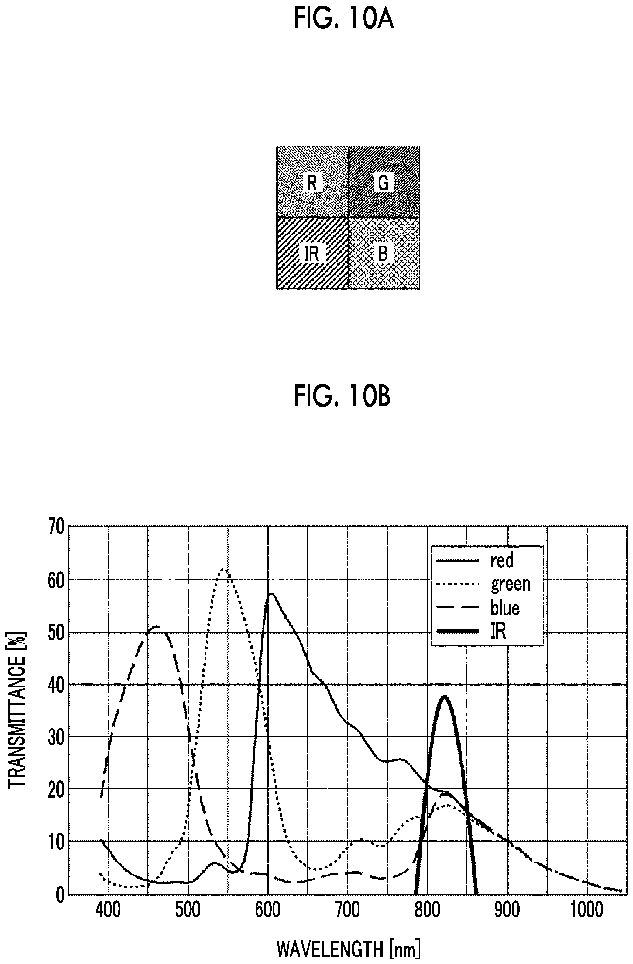

Fig. 10 is a diagram used for describing another embodiment of the distance image sensor (image sensor) which may be applied to the TOF camera 10, and Fig. 10A is a diagram illustrating a basic arrangement of 2×2 pixels of the image sensor of the other embodiment. The image sensor of the other embodiment is a configuration in which the basic arrangement thereof is repeatedly disposed in a horizontal direction and a vertical direction.

As illustrated in Fig. 10A, the basic arrangement of the 2×2 pixels includes a near-infrared ray pixel (infrared (IR) pixel) which is a first light receiving element having sensitivity in a wavelength band of a near-infrared ray, and three second light receiving elements (R pixel, G pixel, and B pixel) having sensitivities in wavelength bands of visible light of a red (R), a green (G), and a blue (B), respectively. That is, the image sensor of the other embodiment is configured by mixing the IR pixel, the R pixel, the G pixel, and the B pixel, and arranging the IR pixel, the R pixel, the G pixel, and the B pixel on a two-dimension.

Fig. 10B illustrates a spectral transmittance of each of color filters of RGB disposed in the R pixel, the G pixel, and the B pixel, and a spectrum characteristic of the near-infrared ray emitted from the pulse light emitting unit 22 (near-infrared LED).

The distance image is read from the IR pixel of the image sensor of the above described configuration, and it is possible to acquire the distance image which indicates the distance of the object on the basis of a signal electric charge corresponding to the near-infrared ray which is emitted from the pulse light emitting unit 22 and reflected from the object.

In addition, a visualization image generation unit (not shown) in the CPU 20 may generate a color image (visualization image) of the subject in the capture area from the image of the RGB read from the R pixel, the G pixel, and the B pixel of the above described image sensor. Each of the filters of the RGB has transmittance even to the near-infrared ray. However, each of the filters may have a structure in which corresponding R pixel, G pixel, and B pixel do not have sensitivities to the near-infrared ray. Alternatively, it is possible to generate the visualization image which does not have sensitivity to the near-infrared ray by providing an IR cut filter to each of the filters of the RGB so that the IR cut filter overlaps each of the filters. In addition, the visualization image may be generated by installing a visible light cut filter instead of the near-infrared ray filter having a band pass characteristic in Fig. 10B, rather than the IR cut filter or the structure does not have sensitivity to the near-infrared ray, and subtracting IR image ingredient from each of the images of the RGB read from the R pixel, the G pixel, and the B pixel.

According to the image sensor of the above described configuration, it is possible to capture the distance image and the visualization image (color image) by one image sensor. In addition, in this case, it is preferable that the captured distance image and the visualization image (color image) are related to each other and stored in the database 120.

[Drawing creation method]

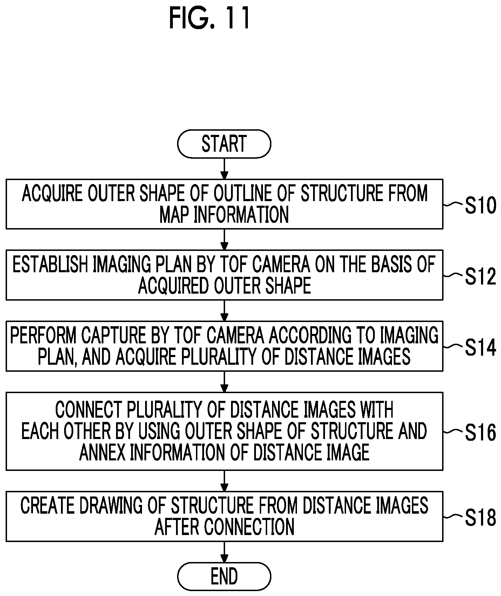

Fig. 11 is a flowchart illustrating an embodiment of a drawing creation method according to the present invention.

In Fig. 11, the outer shape acquisition unit 130 of the drawing creation apparatus main body 100 illustrated in Fig. 1 acquires the outer shape of the outline of the structure from the map information 170 (step S10).

The estimation unit 160 establishes an imaging plan such as, the imaging position, imaging direction, and the number of the times of capturing by the TOF camera 10 from the outer shape of the structure (bridge 1) acquired by the outer shape acquisition unit 130 (step S12). The photographer performs the capture (capture of distance image) of the structure by the TOF camera 10 according to the imaging plan in step S12. The distance image acquisition unit of the drawing creation apparatus main body 100 acquires the distance images of the plurality of portions configuring the structure captured by the TOF camera 10 (step S14).

Then, the connection processing unit 140 connects the distance images of the plurality of portions with each other acquired in step S14, by using the outer shape of the structure acquired in step S10 and the annex information (imaging position and imaging direction) of each distance image (step S16).

Next, the drawing creation unit 150 creates the drawing of the structure from the distance images (three-dimensional information of the entire structure) after the connection (step S18).

The drawing of the structure created by the processes described above is made as electronic data or output as a print, and thus may be used in a repair, an inspection, and the like of the structure.

[Others]

In the present embodiment, the structure is divided by a plurality of times (for each of plurality of imaging positions) so that the distance images are captured, however, the present embodiment is not limited thereto. The distance image may be successively captured in a regular frame rate while successively changing (shifting) the imaging position, and images of the plurality of portions to be successively used may be extracted (acquired) from among the plurality of successively captured distance images.

In addition, in the present embodiment, the outer shape of the outline of the structure which is the creation target of the drawing is acquired from the map information which may be acquired from the GIS, and the like. However, for example, in a case in which information related to the outer shape of the structure such as the length, the width, and the like of a bridge is known in advance, the outer shape may be acquired from the information thereof, and may be acquired by measuring the outer shape of the structure.

Furthermore, the present embodiment is not limited to a case in which the distance image including the annex information indicating the imaging position and the imaging direction is acquired by the wireless communication from the TOF camera, and the distance image may be acquired from the TOF camera by a wired method or through a recording medium of the TOF camera.

In addition, the distance image capture device is not limited to the TOF camera, and may use a three-dimensional laser scanner or a stereo camera. Any device may be used as the distance image capture device as long as the device is a device capable of acquiring a distance image of a necessary structure.

Explanation of References

| 10: | TOF camera |
|---|---|
| 12: | image forming lens |
| 14: | distance image sensor |
| 20: | Central Processing Unit (CPU) |
| 22: | pulse light emitting unit |
| 24: | exposure control unit |
| 28: | display unit |
| 30: | GPS device |
| 32: | azimuth sensor |
| 34: | first communication unit |
| 100: | drawing creation apparatus main body |
| 110: | second communication unit |
| 120: | database |
| 130: | outer shape acquisition unit |
| 140: | connection processing unit |
| 150: | drawing creation unit |
| 152: | dimension appending unit |
| 160: | estimation unit |
| 180: | first manual correction unit |
| 190: | second manual correction unit |
| 200: | unmanned aerial vehicle |
| 210: | remote operation unit |

**Claims**

1. A drawing creation apparatus of a structure, comprising:

an outer shape acquisition unit (130) that acquires an outer shape of an outline of the structure which is a creation target of a drawing;
a distance image capture device (14) that captures the structure, and captures distance images including annex information indicating an imaging position and an imaging direction;
a distance image acquisition unit (16-20) that acquires a plurality of distance images of a plurality of portions configuring the structure, the distance images being obtained by capturing by the distance image capture device;

a connection processing unit (140) that connects the distance images of the plurality of portions with each other which are acquired by the distance image acquisition unit (16-20), by using the outer shape of the structure acquired by the outer shape acquisition unit (130) and the annex information on the distance images; and

a drawing creation unit (150) that creates the drawing of the structure from the distance images connected with each other by the connection processing unit (140);

wherein the distance image capture device comprises a global positioning system (30) and an azimuth sensor (32), and uses GPS information and azimuth information acquired from the global positioning system and the azimuth sensor, respectively, at the time of capturing the distance images, as the annex information indicating the imaging position and the imaging direction.

2. The drawing creation apparatus according to claim 1, wherein the distance image capture device (14) comprises an estimation unit (160) that estimates the number of the times of capturing from the outer dimension of the outline of the structure, and a first notification unit (34) that notifies a result estimated by the estimation unit.

3. The drawing creation apparatus according to any one of claims 1 to 2, wherein the distance image capture device comprises a second notification unit (110) that notifies information indicating which position of the whole structure is captured, in a case in which the structure is captured.

4. The drawing creation apparatus according to any one of claims 1 to 3, further comprising:

a first display unit (28) that displays the distance images as visualization which are captured by the distance image capture device (14); or

a second display unit that displays a visualization image acquired by a capture device which captures the visualization image of the same capture area as that of the distance image capture device.

5. The drawing creation apparatus according to any one of claims 1 to 4, further comprising: a third display unit that displays a previously-captured area where the capture of the distance images is performed with respect to the structure and a non-captured area where the capture of the distance images is not performed with respect to the structure, in a distinguishable manner.

6. The drawing creation apparatus according to any one of claims 1 to 5, wherein the distance image capture device (14) is a time of flight type camera (10).

7. The drawing creation apparatus according to any one of claims 1 to 6, wherein the drawing creation unit (150) creates a diagram formed by connecting points with each other, which are seen as a contour of the structure from the distance images which are connected with each other.

8. The drawing creation apparatus according to any one of claims 1 to 5, further comprising: a first correction unit (180) that corrects the connection of the distance images of the plurality of portions by the connection processing unit (140).

9. The drawing creation apparatus according to any one of claims 1 to 8, further comprising: a second correction unit (190), including a display, the second correction unit correct the drawing of the structure which is created by the drawing creation unit (150) in response to a manually input correction instruction.

10. The drawing creation apparatus according to any one of claims 1 to 9, further comprising: a dimension appending unit (152) that appends a dimension line and a dimension in the drawing of the structure.

11. The drawing creation apparatus according to any one of claims 1 to 10, wherein the outer shape acquisition unit (130) acquires the outer shape of the structure from map information expressing the outer shape of the outline of the structure, and preferably, the map information is map information acquirable from a map information system, or map information provided by a map information provision service on the Internet.

12. The drawing creation apparatus according to any one of claims 1 to 11, further comprising:

an unmanned aerial vehicle that loads the distance image capture device (14), and a control unit that controls the unmanned aerial vehicle, wherein the distance image acquisition unit (16-20) acquires the plurality of distance images which are obtained by capturing by the distance image capture device (40) loaded on the unmanned aerial vehicle.

**13.** The drawing creation apparatus according to any one of claims 1 to 12,

> wherein the distance image capture device (14) successively captures the distance images in a regular frame rate, and
> the distance image acquisition unit (16-20) acquires the images of the plurality of portions used in the connection among the successively captured distance images.

**14.** A drawing creation method carried out in a drawing creation apparatus including a global positioning system (30) and an azimuth sensor (32), the method comprising:

> a step of acquiring (S10) an outer shape of an outline of a structure which is a creation target of a drawing;
> a step of acquiring (S14) a plurality of distance images of a plurality of portions configuring the structure, which are the distance images being acquired by a distance image capture device which captures the structure;
> a step of connecting (S16) the acquired distance images of the plurality of portions with each other, by using the acquired outer shape of the structure and annex information on the distance images, the annex information indicating an imaging position and an imaging direction; and
> a step of creating (S18) the drawing of the structure from the distance images which are connected with each other;
> wherein the step of acquiring (S14) a plurality of distance images uses GPS information and azimuth information acquired from the global positioning system and the azimuth sensor, respectively, at the time of capturing the distance images, as the annex information indicating the imaging position and the imaging direction.

**Patentansprüche**

**1.** Zeichnungserstellungsvorrichtung für eine Struktur, umfassend:

> eine Außengestalt-Erfassungseinheit (130), die eine Außengestalt einer Umrisslinie der Struktur erfasst, die ein Erstellungsziel für die Zeichnung ist;
> eine Distanzbild-Aufnahmeeinrichtung (14), welche die Struktur aufnimmt und Distanzbilder aufnimmt, die Beilageninformation enthalten, welche eine Bildgebungsposition und eine Bildgebungsrichtung angeben;
> eine Distanzbild-Erfassungseinheit (16-20), die mehrere Distanzbilder mehrerer, die Struktur konfigurierender Abschnitte erfasst, wobei die Distanzbilder erhalten werden durch Aufnehmen mit der Distanzbild-Aufnahmeeinrichtung;
eine Verbindungsverarbeitungseinheit (140), welche die Distanzbilder der mehreren Abschnitte, die von der Distanzbild-Erfassungseinheit (16-20) erfasst wurden, miteinander verbindet unter Verwendung der Außengestalt der Struktur, die von der Außengestalt-Erfassungseinheit (130) erfasst wurde, und der Beilageninformation an den Distanzbildern; und
eine Zeichnungserstellungseinheit (150), welche die Zeichnung der Struktur aus den Distanzbildern erstellt, die miteinander von der Verbindungsverarbeitungseinheit (140) verbunden wurden;
wobei die Distanzbild-Aufnahmeeinrichtung ein globales Positionsbestimmungssystem (30) und einen Azimuthsensor (32) aufweist und GPS-Information sowie Azimuth-Information, die von dem globalen Positionsbestimmungssystem bzw. dem Azimuthsensor erhalten wird, zur Zeit der Aufnahme der Distanzbilder als die Beilageninformation verwendet, welche die Bildgebungsposition und die Bildgebungsrichtung angeben.

**2.** Vorrichtung nach Anspruch 1,
bei der die Distanzbild-Aufnahmeeinrichtung (14) eine Abschätzeinheit (160) aufweist, die die Anzahl der Aufnahmevorgänge für die Außenabmessung der Umrisslinie der Struktur abschätzt, ferner eine erste Meldeeinheit (34), die ein von der Abschätzeinheit abgeschätztes Ergebnis meldet.

**3.** Vorrichtung nach einem der Ansprüche 1 bis 2,
bei der die Distanzbild-Aufnahmeeinrichtung eine zweite Meldeeinheit (110) enthält, die Information meldet, welche angibt, welche Position der Gesamtstruktur aufgenommen wird, wenn die Struktur aufgenommen wird.

**4.** Vorrichtung nach einem der Ansprüche 1 bis 3, weiterhin umfassend:

> eine erste Anzeigeeinheit (28), welche als Visualisierung die Distanzbilder anzeigt, die von der Distanzbild-Aufnahmeeinrichtung (14) aufgenommen werden; oder
> eine zweite Anzeigeeinheit, die ein Visualisierungsbild anzeigt, erfasst durch die Aufnahmeeinrichtung, welche das Visualisierungsbild des gleichen Aufnahmebereichs wie der der Distanzbild-Aufnahmeeinrichtung aufnimmt.

**5.** Vorrichtung nach einem der Ansprüche 1 bis 4, weiterhin umfassend:
eine dritte Anzeigeeinheit, die einen zuvor aufgenommenen Bereich anzeigt, wo die Aufnahme der Distanzbilder in Bezug auf die Struktur ausgeführt wird, und einen nicht-aufgenommenen Bereich anzeigt, wo die Aufnahme der Distanzbilder in Bezug auf die Struktur nicht ausgeführt wird, und zwar in einer unterscheidbaren Weise.

6. Vorrichtung nach einem der Ansprüche 1 bis 5, bei der die Distanzbild-Aufnahmeeinrichtung (14) eine Laufzeitkamera (10) ist.

7. Vorrichtung nach einem der Ansprüche 1 bis 6, bei der die Zeichnungserstellungseinheit (150) ein Diagramm erstellt, gebildet durch Verbinden solcher Punkte miteinander, die aus den miteinander verbundenen Distanzbildern als eine Kontur der Struktur gesehen werden.

8. Vorrichtung nach einem der Ansprüche 1 bis 5, weiterhin umfassend:
eine erste Korrektureinheit (180), welche die Verbindung der Distanzbilder der mehreren Abschnitte durch die Verbindungsverarbeitungseinheit (140) korrigiert.

9. Vorrichtung nach einem der Ansprüche 1 bis 8, weiterhin umfassend:
eine zweite Korrektureinheit (190) einschließlich eines Displays, wobei die zweite Korrektureinheit die Zeichnung der Struktur korrigiert, die von der Zeichnungserstellungseinheit (150) erstellt wird, ansprechend auf einen manuell eingegebenen Korrekturbefehl.

10. Vorrichtung nach einem der Ansprüche 1 bis 9, weiterhin umfassend:
eine Dimensionsbeifügeeinheit (152), die eine Dimensionslinie und eine Dimension in der Zeichnung der Struktur beifügt.

11. Vorrichtung nach einem der Ansprüche 1 bis 10, bei der die Außengestalt-Erfassungseinheit (130) die Außengestalt der Struktur aus Karteninformation erfasst, die die Außengestalt der Umrisslinie der Struktur zum Ausdruck bringt, und vorzugsweise die Karteninformation eine solche Karteninformation ist, die aus einem Karteninformationssystem erfassbar ist, oder Karteninformation, die durch einen Karteninformations-Lieferdienst im Internet geliefert wird.

12. Vorrichtung nach einem der Ansprüche 1 bis 11, weiterhin umfassend:

ein unbemanntes Luftfahrzeug, welches die Distanzbild-Aufnahmeeinrichtung (14) und eine das unbemannte Luftfahrzeug steuernde Steuereinheit trägt,
wobei die Distanzbild-Erfassungseinheit (16-20) die mehreren Distanzbilder erfasst, die erhalten werden durch Aufnehmen durch die in dem unbemannten Luftfahrzeug befindliche Distanzbild-Aufnahmeeinrichtung (40).

13. Vorrichtung nach einem der Ansprüche 1 bis 12, bei der die Distanzbild-Aufnahmeeinrichtung (14) sukzessive die Distanzbilder mit einer regelmäßigen Einzelbildrate aufnimmt, und
die Distanzbild-Erfassungseinheit (16-20) die Bilder der mehreren Abschnitte aufnimmt, die in der Verbindung unter den sukzessive aufgenommenen Distanzbildern verwendet werden.

14. Zeichnungserstellungsverfahren, durchgeführt in einer Zeichnungserstellungsvorrichtung, welche ein globales Positionsbestimmungssystem (30) und einen Azimuthsensor (32) aufweist, umfassend:

einen Schritt des Erfassens (S10) einer Außengestalt einer Umrisslinie einer Struktur, die ein Erstellungsziel für die Zeichnung ist;
einen Schritt des Erfassens (S14) mehrerer Distanzbilder mehrerer Abschnitte, die die Struktur konfigurieren, wobei es sich um die Distanzbilder handelt, die von einer Distanzbild-Aufnahmeeinrichtung erfasst werden, welche die Struktur aufnimmt;
einen Schritt des Verbindens (S16) der erfassten Distanzbilder der mehreren Abschnitte miteinander unter Verwendung der erfassten Außengestalt der Struktur und Beilageninformation an den Distanzbildern, wobei die Beilageninformation die Bildgebungsposition und eine Bildgebungsrichtung angibt; und
einen Schritt des Erstellens (S18) der Zeichnung der Struktur anhand der Distanzbilder, die miteinander verbunden sind;
wobei der Schritt des Erfassens (S14) mehrerer Distanzbilder GPS-Information und Azimuthinformation verwendet, die von dem globalen Positionsbestimmungssystem bzw. dem Azimuthsensor erfasst werden zur Zeit der Aufnahme der Distanzbilder, als Beilageninformation, welche die Bildgebungsposition und die Bildgebungsrichtung angibt.

## Revendications

1. Appareil de création de dessin d'une structure, comprenant :

une unité d'acquisition de forme extérieure (130), laquelle acquiert une forme extérieure d'un contour de la structure, laquelle est une cible de création d'un dessin ;
un dispositif de capture d'image de distance (14), lequel capture la structure, et capture des images de distance incluant des informations complémentaires indiquant une position d'imagerie et une direction d'imagerie ;

une unité d'acquisition d'image de distance (16-20), laquelle acquiert une pluralité d'images de distance d'une pluralité de portions configurant la structure, les images de distance étant obtenues par capture par le dispositif de capture d'image de distance ;

une unité de traitement de liaison (140), laquelle relie les images de distance de la pluralité de portions entre elles, lesquelles sont acquises par l'unité d'acquisition d'image de distance (16-20), en utilisant la forme extérieure de la structure acquise par l'unité d'acquisition de forme extérieure (130) et les informations complémentaires sur les images de distance, et

une unité de création de dessin (150), laquelle crée le dessin de la structure à partir des images de distance reliées entre elles par l'unité de traitement de liaison (140) ;

dans lequel le dispositif de capture d'image de distance comprend un système de mondial de localisation (GPS, Global Positioning System) (30) et un capteur d'azimut (32), et utilise des informations GPS et des informations azimutales acquises respectivement à partir du système de mondial de localisation et du capteur d'azimut respectivement au moment de la capture des images de distance, comme informations complémentaires indiquant la position d'imagerie et la direction d'imagerie.

2. Appareil de création de dessin selon la revendication 1,
dans lequel le dispositif de capture d'image de distance (14) comprend une unité d'estimation (160), laquelle estime le nombre de fois pour la capture de la dimension extérieure du contour de la structure, et une première unité de notification (34) laquelle notifie un résultat estimé par l'unité d'estimation.

3. Appareil de création de dessin selon l'une quelconque des revendications 1 à 2,
dans lequel le dispositif de capture d'image de distance comprend une seconde unité de notification (110), laquelle notifie des informations indiquant la position de la structure complète qui est capturée, dans cas où la structure est capturée.

4. Appareil de création de dessin selon l'une quelconque des revendications 1 à 3, comprenant en outre :

une première unité d'affichage (28), laquelle affiche les images de distance comme visualisation, lesquelles sont capturées par le dispositif de capture d'image de distance (14), ou

une deuxième unité d'affichage, laquelle affiche une image de visualisation acquise par un dispositif de capture, lequel capture l'image de visualisation de la même zone de capture que celle du dispositif de capture d'image de distance.

5. Appareil de création de dessin selon l'une quelconque des revendications 1 à 4, comprenant en outre :
une troisième unité d'affichage, laquelle affiche une zone capturée auparavant, où la capture des images de distance est réalisée par rapport à la structure, et une zone non capturée, où la capture des images de distance n'est pas réalisée par rapport à la structure, d'une manière distincte.

6. Appareil de création de dessin selon l'une quelconque des revendications 1 à 5,
dans lequel le dispositif de capture d'image de distance (14) est une caméra de type à temps de vol (10).

7. Appareil de création de dessin selon l'une quelconque des revendications 1 à 6,
dans lequel l'unité de création de dessin (150) crée un schéma formé en reliant des points entre eux, lesquels sont vus sous la forme d'un contour de la structure à partir des images de distance reliées entre elles.

8. Appareil de création de dessin selon l'une quelconque des revendications 1 à 5 comprenant en outre :
une première unité de correction (180), laquelle corrige la liaison des images de distance de la pluralité de portions par l'unité de traitement de liaison (140).

9. Appareil de création de dessin selon l'une quelconque des revendications 1 à 8, comprenant en outre :
une seconde unité de correction (190), incluant un affichage, la seconde unité de correction corrigeant le dessin de la structure créé par l'unité de création de dessin (150) en réaction à une instruction de correction entrée manuellement.

10. Appareil de création de dessin selon l'une quelconque des revendications 1 à 9, comprenant en outre :
une unité d'ajout de dimension (152), laquelle ajoute une ligne de cote et une dimension dans le dessin de la structure.

11. Appareil de création de dessin selon l'une quelconque des revendications 1 à 10,
dans lequel l'unité d'acquisition de forme extérieure (130) acquiert la forme extérieure de la structure à partir d'informations cartographiques exprimant la forme extérieure du contour de la structure, et de préférence, les informations cartographiques sont des informations cartographiques pouvant être acquises à partir d'un système d'informations cartographiques, ou d'informations cartographiques fournies par un service de fourniture d'informations cartographiques sur Internet.

12. Appareil de création de dessin selon l'une quelconque des revendications 1 à 11, comprenant en outre :

un véhicule aérien sans pilote, lequel charge le dispositif de capture d'image de distance (14), et une unité de commande, laquelle commande le véhicule aérien sans pilote, et dans lequel l'unité d'acquisition d'image de distance (16-20) acquiert la pluralité d'images de distance obtenues par capture par le dispositif de capture d'image de distance (40) chargé dans le véhicule aérien sans pilote.

13. Appareil de création de dessin selon l'une quelconque des revendications 1 à 12, dans lequel le dispositif de capture d'image de distance (14) capture de manière successive les images de distance avec une fréquence d'images régulière, et l'unité d'acquisition d'image de distance (16-20) acquiert les images de la pluralité portions utilisées pour la liaison parmi les images de distance capturées de manière successive.

14. Procédé de création de dessin mis en œuvre dans un appareil de création de dessin incluant un système de mondial de localisation (30) et un capteur d'azimut (32), le procédé, comprenant les étapes suivantes :

une étape pour acquérir (S10) une forme extérieure d'un contour d'une structure, laquelle est une cible de création d'un dessin ; une étape pour acquérir (S14) une pluralité d'images de distance d'une pluralité de portions configurant la structure, lesquelles sont les images de distance acquises par un dispositif de capture d'image de distance, lequel capture la structure ; une étape pour relier (S16) les images de distance acquises de la pluralité de portions entre elles, en utilisant la forme extérieure acquise de la structure et les informations complémentaires sur les images de distance, les informations complémentaires indiquant une position d'imagerie et une direction d'imagerie, et une étape pour créer (S 18) le dessin de la structure à partir des images de distance, lesquelles sont reliées entre elles ; dans lequel l'étape pour acquérir (S14) une pluralité d'images de distance utilise des informations GPS et des informations azimutales acquises respectivement à partir du système de mondial de localisation et du capteur d'azimut respectivement au moment de la capture des images de distance, comme informations complémentaires indiquant la position d'imagerie et la direction d'imagerie.

# FIG. 1

DRAWING CREATION APPARATUS MAIN BODY — 100

10

110 — SECOND COMMUNICATION UNIT
112 — RECEPTION UNIT
114 — TRANSMISSION UNIT

120 — DB

140 — CONNECTION PROCESSING UNIT

152 — DIMENSION APPENDING UNIT
150 — DRAWING CREATION UNIT

160 — ESTIMATION UNIT

130 — OUTER SHAPE ACQUISITION UNIT

180 — FIRST MANUAL CORRECTION UNIT

190 — SECOND MANUAL CORRECTION UNIT

170 — MAP INFORMATION

# FIG. 2

EP 3 358 480 B1

FIG. 3A FIRST EXPOSURE CONTROL

FIG. 3B SECOND EXPOSURE CONTROL

FIG. 3C OPERATION PROCESSING

## FIG. 4

## FIG. 5

# FIG. 6

22m

65m

Y

X

10 DIVISIONS (12 CAPTURES ➡ 10 TIMES IN DIRECTION, ⇐ TWICE IN DIRECTION)

# FIG. 7

# FIG. 8

# FIG. 9

# FIG. 10A

# FIG. 10B

# FIG. 11

```
                    ┌─────────────┐
                    │    START    │
                    └─────────────┘
                           │
                           ▼
┌──────────────────────────────────────────────────┐
│  ACQUIRE OUTER SHAPE OF OUTLINE OF STRUCTURE FROM  │   S10
│                  MAP INFORMATION                   │
└──────────────────────────────────────────────────┘
                           │
                           ▼
┌──────────────────────────────────────────────────┐
│ ESTABLISH IMAGING PLAN BY TOF CAMERA ON THE BASIS OF│  S12
│              ACQUIRED OUTER SHAPE                   │
└──────────────────────────────────────────────────┘
                           │
                           ▼
┌──────────────────────────────────────────────────┐
│ PERFORM CAPTURE BY TOF CAMERA ACCORDING TO IMAGING │   S14
│   PLAN, AND ACQUIRE PLURALITY OF DISTANCE IMAGES   │
└──────────────────────────────────────────────────┘
                           │
                           ▼
┌──────────────────────────────────────────────────┐
│        CONNECT PLURALITY OF DISTANCE IMAGES WITH    │
│   EACH OTHER BY USING OUTER SHAPE OF STRUCTURE AND  │   S16
│        ANNEX INFORMATION OF DISTANCE IMAGE         │
└──────────────────────────────────────────────────┘
                           │
                           ▼
┌──────────────────────────────────────────────────┐
│  CREATE DRAWING OF STRUCTURE FROM DISTANCE IMAGES   │   S18
│                AFTER CONNECTION                    │
└──────────────────────────────────────────────────┘
                           │
                           ▼
                    ┌─────────────┐
                    │     END     │
                    └─────────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004272459 A
- JP 2010236971 A
- US 2005201611 A1